# EUROPEAN PATENT SPECIFICATION

(11) **EP 3 555 976 B1**
(45) Date of publication and mention of the grant of the patent: **06.04.2022**
(21) Application number: 17811971.5
(22) Date of filing: 15.12.2017
(51) Int. Cl.: H02G 5/00, H05K 1/02, H05K 3/46, B32B 15/08, H01B 5/14, H02B 1/21, H05K 1/11

(54) **REINFORCED MULTI-PHASE BUSBAR FOR CONDUCTING ELECTRIC ENERGY AND METHOD OF MANUFACTURING THE SAME**
VERSTÄRKTE LAMINIERTE MEHRPHASIGE SAMMELSCHIENE UND VERFAHREN ZUR HERSTELLUNG DAVON
BARRE OMNIBUS MULTIPHASE LAMINÉE RENFORCÉE ET SON PROCÉDÉ DE FABRICATION

(30) Priority: 19.12.2016 EP 16205013; 19.12.2016 EP 16205020; 19.12.2016 EP 16205023
(43) Date of publication of application: 23.10.2019
(73) Proprietor: ABB Schweiz AG, 5400 Baden (CH)
(72) Inventor: VELTHUIS, Rudi, 79787 Lauchringen (DE); KRIVDA, Andrej, 5430 Wettingen (CH); ROCKS, Jens, 8807 Freienbach (CH)
(74) Representative: Kesselhut, Wolf
(86) International application number: PCT/EP2017/083064
(87) International publication number: WO 2018/114690

(56) References cited:
- DE-A1-102005 015 945
- GB-A- 1 030 283
- US-A- 3 663 866
- US-A- 4 358 633
- US-A1- 2005 257 957
- US-B1- 6 329 603

## Description

The invention is defined by the appended claims 1 and 14.

Multi-phase busbars are used in switchboards and/or switchgears in particular low voltage switchgears, to conduct and distribute alternating electrical current to different electrical devices which are usually installed in switch gear cabinets. In order to provide for the possibility to conduct all three phases or even more phases of an alternating current in a single busbar, multi-phase busbars have been developed which comprise a base layer and a cover layer of electrically insulating material between which two or more layers of conducting sheet metal, in particular copper, are arranged that are electrically insulated from each other by means of insulating intermediate layers.

An afore-described busbar in which the different layers are laminated to each other by means of liquid resin is described in DE 10 2005 015 945 B4 of the applicant. The laminated busbar has the advantage that it is compact and does not tend to delaminate due to repellant forces which are generated by the alternating electric currents that are conducted in the different conducting layers for each phase and which in case of a short circuit can be in the range of several thousand ampere (kA). One problem of the busbars as described in DE 10 2005 015 945 B4 are the costs involved in the lamination process itself in which the different layers are bond to each other by means of a liquid resin, like epoxy resin, which is applied to the upper and lower side of each layer and cured afterwards. As the laminating resins used for the laminating process are usually toxic and are said to cause allergic reactions, specific safety precautions for the staff are required in the production process which significantly raise the production costs. Documents US 3,663,866A, US 6,329,603 B1, US 4,358,633 A disclose alternative multi-phase busbar constructions.

Accordingly, it is a problem of the present invention to provide for a multi-phase busbar which can be manufactured at reduced efforts and costs without the extensive application of a liquid resin to each layer for bonding the layers to each other.

This problem is solved by a multi-phase busbar and a method of manufacturing the same as claimed in claims 1 and 14.

Further objects of the present invention are included in the dependent claims.

The invention has the following technical advantages:
- High reliability as all copper plates are coated before the resin is cast around the pins. No additional machining or cover/coating on the pins and shipping splits are required.

- High flexibility on the arrangement of the pins as only the area around the pins is casted and no complex mold is required.
- The busbar according to the inventions provides for the same size and loss reduction as a conventionally laminated busbar,
- The combined layer and casting concept of the invention allows a highly automated processing of multi-phase busbars

Moreover, the invention has the following economical advantages:
- Reduced handling steps as no complex mold is required. Especially, no tight sealing around the pins and shipping split areas are needed as the local clamping proved to be sufficient.
- The casting can be performed without the use of vacuum if an appropriate resin is used.
- No cleaning of the mold is required.
- Reduced tooling costs as the machined/molded area around the pins itself is used as a mold.

In general lower production costs and faster assembly of the busbar compared to currently used systems.

The invention is hereinafter described with reference to the accompanying drawings and following description.

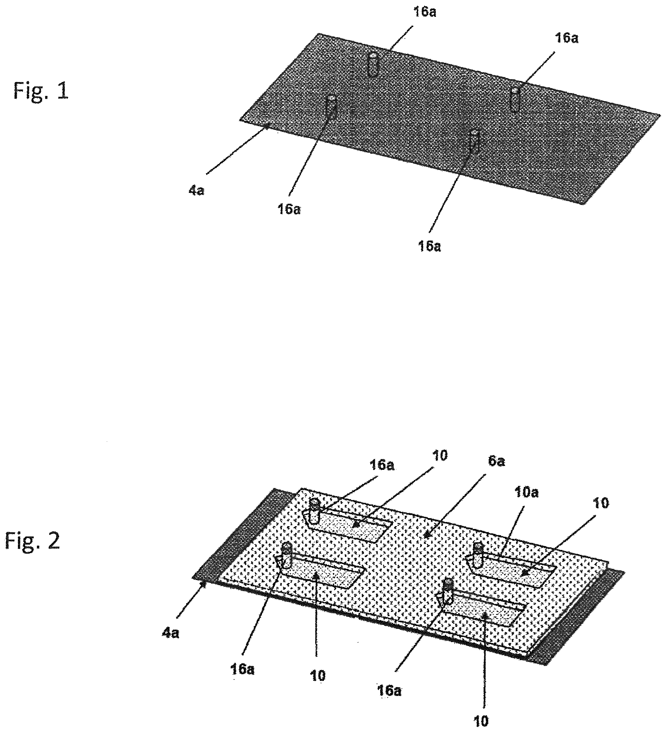

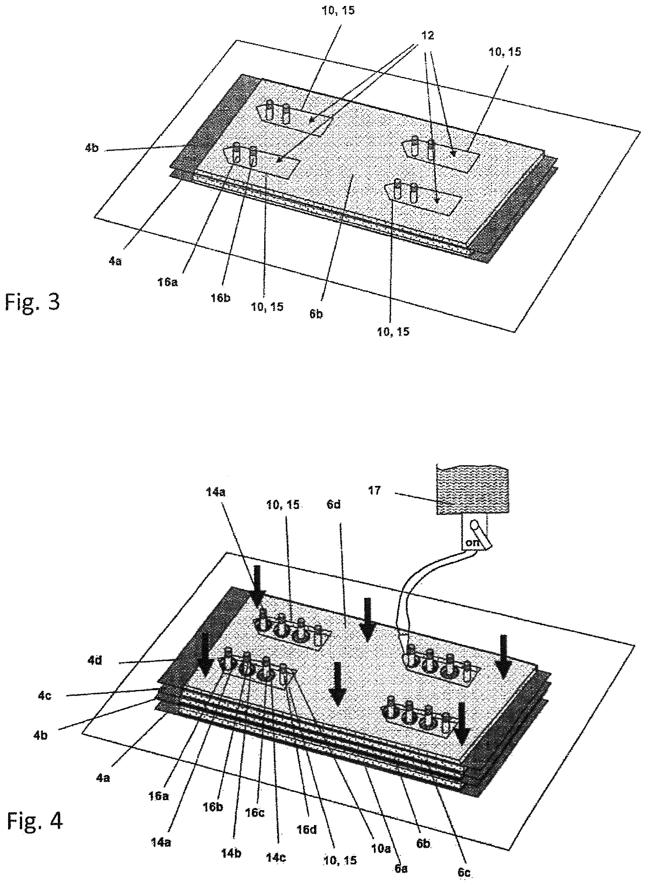

In the drawings
- Fig. 1: is a schematic view of a first uncoated conducting layer,
- Fig.2: is a schematic view of the conducting layer of Fig. 1 after positioning a first layer of rigid insulating material on the electrically conducting surface,
- , Fig. 3: is a schematic view of the busbar of Fig. 2 after positioning second conducting layer and a second layer of rigid insulating material on the second conducting layer and filling up the common recess through with curable resin, to provide a minimum-configuration of a busbar having only two conducting layers,
- Fig. 4: is a schematic view of the busbar of Fig. 3 after arranging a third and fourth conducting layer and a second, third and fourth intermediate layer of rigid insulating material on the second conducting layer according to another preferred embodiment of the invention while pressing the layers together and casting resin into the common recesses around the first conducting pins,

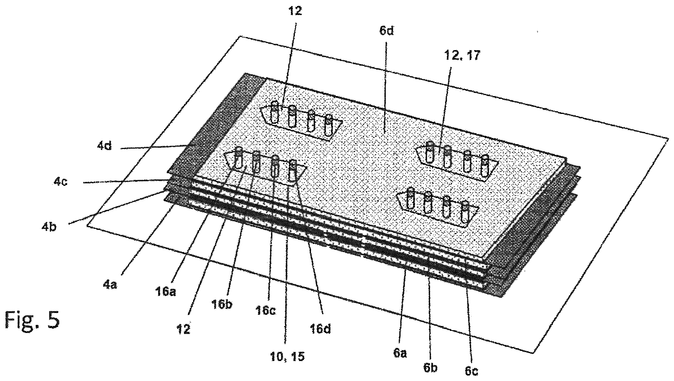

- Fig. 5: is a schematic view of the final product of a busbar of Fig. 4 after curing the resin.

As it is shown in Fig. 1, a multi-phase busbar 1 for conducting electric energy, comprises a first conducting layer 4a which is made of a sheet metal, preferably copper or aluminium, which can have a thickness of 0.5 to 5 mm or even more. The first conducting layer 4a comprises at least one first conducting pin 16a, which extends in a direction perpendicular to the first conducting layer 4a and which is either integrally formed with the conducting layer 4a when manufacturing the same or which is soldered or mechanically attached to the sheet metal by screwing or clamping.

Optionally a coating of an electrically insulating material, preferably epoxy resin may be applied to the first conducting pins 16a except at the contacting portions at the tops of the first conducting pins 16a which in the final product serves for electrically connecting the first conducting layer 4a to shipping splits and to electric devices (not shown).

On the first conducting layer 4a, a first insulating layer 6a of a rigid insulating material is loosely positioned as it is shown in Fig. 2. The layer 6a is preferably a machined GPO-3 plate material or an other known composite material which is composed of reinforcing fibers and a cured resin. The first insulating layer 6a which may have a thickness of 1 mm to 5 mm or more depending on the specific operational purpose and design of the busbar, comprises an opening 10 which extends at least around the area of the first conducting pin 16a and preferably also underneath the area, where the second conducting pin 16b is positioned when positioning a second conducting layer 4b on the first insulating layer 6a as it is shown in Fig. 3. As it is further indicated by dashed lines in Fig. 4, further openings 10 may be formed in the first insulating layer 6a of rigid insulating material in the sections where further first and second conducting pins 16a, 16b are mounted to the first conducting layers 4a, 4b, so that there may be formed four or even more of such openings 10 each of which is having a continues edge 10a which surrounds at least the first and the second conducting pins 16a, 16b.

As it can further be seen from Fig. 4, the second conducting layer 4b comprises a first pinhole 14a around each of the conducting pins 16a through which the first conducting pins 16a project, respectively. This first pinhole 14a communicates with the opening 10 in the first insulating layer 6a and thereby defines a common recess 15 through which the first conducting pins 16a project.

As a next step for producing a multi-phase busbar 1 having two conducting layers 4a, 4b which represents the minimum configuration of a busbar according to the present invention, the entire stack including the two conducting layers 4a, 4b and also the first insulating layer 6a is aligned. This alignment may be done by means of a mask (not shown) which comprises holes at the positions where the first and second conducting pins 16a, 16b are located, and stops (not shown) against which the edges of the layers may abut.

In a next step the common recesses 15 are filled up with a curable resin 17 which is injected into the first pinholes 16a and penetrates into the openings 10, as it will be described hereinafter with reference to Fig. 4, in which the preferred embodiment of a busbar 1 is shown which comprises four conducting layers 4a to 4d.

While filling the recesses 15 with the curable resin 17, pressure is applied to the upper and lower layers of the stack as it is indicated by arrows F in Fig. 4.

The pressure F which is preferably applied as a clamping force by vises (not shown) avoids that the resin 17 penetrates from the common recesses 15 into gaps which may be formed between the different layers.

The resin 17 may be a 2-component resin formulation which is prepared by mixing the two components right before filling up the common recesses 15, but may also be a thermosetting resin. The resin 17 may optionally include a photoinitiator, in particular a UV-initiator which can be activated by applying UV-light from a light source (not shown) in order to provide for an initial bonding of the layers 4a, 4b and 6a prior to a final curing of the resin. This advantageously allows the positioning masks to be removed right after the initial UV-curing of the resin in the first pinholes 14a which can then be used for the production of a next busbar 1.

After the curing of the resin 17, which may also be accelerated by putting the stack into an oven, the resin 17 in the common recesses 15 forms a material bridge 12 between the first conducting layer 4a, the first insulating layer 6a and the second conducting layer 4b which mechanically clamps said first conducting layer 4a, said first rigid insulating layer 6a and said second conducting 4b layer together.

According to another embodiment of a busbar 1 having two conducting layers 4a, 4b, a second insulating layer 6b of a rigid insulating material is arranged on the second conducting layer 4b, as it is shown in Fig. 3. The second rigid insulating layer 6 is preferably identical to the first rigid insulating layer 6a and comprises an opening 10 which surrounds the first and second conducting pins 16a, 16b and matches the first pinhole 14a, so that the first pinhole 14a in the second conducting layer 4b and the openings 10 in the first rigid insulating layers 6a, 6b are in fluid communication and define a common recess 15 in which the first and the second conducting pins 16a, 16b project in parallel to each other.

In order to permanently clamp the four layers 4a, 4b, 6a and 6b together, the stack of loosely superposed layers is aligned and mechanically pressed together while filling the liquid curable resin 17 into the common recess 15. As it can be seen from Fig. 3, the liquid resin 17 is fed into the common recess 15 until the entire opening 10 in the second rigid insulating layer 6b which forms a part of the common recess 15 is entirely filled up with resin. After the curing of the resin, the resin in the filled up recess 5 also forms part of the material bridge 12 which advantageously comprises an enlarged clamping area.

According to the preferred embodiment of a busbar 1 which comprises altogether 4 electrically conducting layers 4a, 4b, 4c and 4d, a third and a fourth layer 4c, 4d of a conducting material and a third layer 6c of a rigid insulating material are arranged above each other on the second layer 6b of rigid insulating material, as it is shown in Fig. 4. The third conducting layer 4c comprises a first and second pinhole 14a, 14b, whereas the fourth conducting layer comprises a first, second and third pinhole 14a, 14b, 14c, in the centers of which the three conducting pins 16a to 16c are preferably centrally arranged, respectively. The third layer 6c of rigid material which is preferably identical to the other layers 6a and 6b comprises an opening 10 (indicated in dashed lines) which is in fluid communication with the first, second and third pinholes 14 in the conducting layers 4b to 4d as well as the openings 10 in the first, second and third layers 6a 6b, 6c of rigid insulating material and forms part of a common recess 15 in which the first, second and third conducting pins 16a, 16b and 16c project. In the same way as described herein before the stack of layers is aligned and clamped together before filling in the liquid resin 17. The resin 17 is preferably injected into the openings 14a which extend through all layers except the lower conducting layer 4a. After the curing of the resin which may also include reinforcing fibers (not shown) the hardened resin forms a material bridge 12 which mechanically clamps the conducting layers 4a, 4b and the layers 6a to 6c of rigid insulating material together as it is shown in Fig. 5.

As the applicant has found, the clamping of the layers by the material bridges 12 of cured resin also increase the shear resistance of the stack in a lateral direction, that is in the plane of the layers, due to the frictional forces generated. This in turn reduces the danger of a delamination of the busbars 1 by the repellant magnetic forces which are generated in case of a short circuit.

According to an even more sophisticated embodiment of the invention which is shown in Fig. 5, a fourth layer of rigid insulating material 6d is arranged on said fourth insulating layer 4d. The fourth insulating layer 4d comprises an opening 10 which matches the first second and third pinholes 14a, 14b and 14c in said first second and third conducting layers 4a to 4c and is in fluid communication with the openings 10 which are formed in the first, second and third layers 6a to 6c of rigid insulating material and the pinholes 14a to 14c in the conducting layers 4a to 4c. The opening 10 in the fourth layer 6d of rigid insulating material forms part of a common recess 15 which is filled up with a curable resin as shown in Fig. 5, in order to generate a material bridge 12 which mechanically clamps the sandwich of conducting layers 4a to 4d and rigid insulating layers 6a to 6d in the final busbar 1 as it is shown in Fig. 5.

In the afore-described embodiments of the invention, the layers 4d and 6d are advantageously mechanically attached to each other by the material bridges of the cured resin 12 only, without employing additional adhesives between the layers.

In the preferred embodiments of the invention, the openings 10 in the first layer 6a and/or second layer 6b and/or third layer 6c and/or fourth layer 6d of rigid insulating material cover an area which is larger, preferably at least four times as large, as the area which is covered by the cross section of the first, second and third pinhole 14 a to 14c which are preferably identical in shape. By means of this, a toothing interaction of the material bridges 12 is generated which further increases the mechanical stability of the busbar 1.

In a further embodiment, which is not a part of the claimed invention, additional adhesives may be applied between the layers to further increase the mechanical stability and to facilitate the production process.

Although not part of the claimed invention, all layers and insulating materials or sheets may be fixed and/ or coated by any possible mechanical or chemical method, especially with or without casting, with or without glueing or with or without epoxy coating.

### Listing of reference numerals

- 1: busbar
- 4a: first conducting layer
- 4b: second conducting layer
- 4c: third conducting layer
- 4d: fourth conducting layer
- 6a: first intermediate layer
- 6b: second intermediate layer
- 6c: third intermediate layer
- 6d: fourth intermediate layer
- 10: opening
- 10a: continuous edge of opening
- 12: material bridges
- 14a: first pinholes
- 14b: second pinholes
- 14c: third pinholes
- 15: common recess
- 16a: first conducting pins
- 16b: second conducting pins
- 16c: third conducting pins
- 16d: fourth conducting pins
- 17: resin
- F: compressive force

## Claims

1. Multi-phase busbar (1) for conducting electric energy, comprising a first conducting layer (4a) made of a sheet metal, a first conducting pin (16a) mounted to said first conducting layer (4a) which extends in a direction perpendicular to the first conducting layer (4a), a first insulating layer (6a) of a rigid insulating material arranged on said first conducting layer (4a), said first insulating layer (6a) having an opening (10) through which the first conducting pin (16a) projects, a second conducting layer (4b) made of a sheet metal, said second conducting layer (4b) comprising a first pinhole (14a) through which said first conducting pin (16a) projects and a second conducting pin (16b) which extends in a direction parallel to said first conducting pin (16a), wherein said opening (10) in said first insulating layer (6a) and said first pinhole (14a) in said second conducting layer (4b) define a common recess (15) through which said first conducting pin (16a) projects,
**characterized in that** said opening (10) in the first layer (6a) of rigid insulating material comprises an area which is larger than the area of the cross section of the first pinhole (14a), and that said common recess (15) is filled with a hardened resin (17) which forms a material bridge (12) between the first conducting layer (4a) and the second conducting layer (4b), which mechanically clamps said first conducting layer (4a), said first rigid insulating layer (6a) and said second conducting (4b) layer together.

2. Multi-phase busbar according to claim 1, **characterized in that** a second insulating layer (6b) of a rigid insulating material is arranged on said second conducting layer (4b), said second layer (6b) of rigid insulating material having an opening (10) which matches said first pinhole (14a), said first pinhole (14a) in said second conducting layer (4b) and said openings (10) in said first and second layers (6a, 6b) of insulating material defining a common recess (15) in which the first and the second conducting pin (16a, 16b) are located and which is filled with resin (17) forming a material bridge (12) which mechanically clamps said first and second conducting layers (4a, 4b) and said first and second rigid insulating layers (6a, 6b) together.

3. Multi-phase busbar according to claim 1 or 2, **characterized in that** a third and a fourth layer (4c, 4d) of a conducting material and a third layer (6c) of a rigid insulating material are arranged above each other on said second layer (6b) of rigid insulating material, wherein said third conducting layer (4c) comprises a first and second pinhole (14a, 14b), said fourth conducting layer comprises a first, second and third pinhole (14a, 14b, 14c) and said third layer (6c) of rigid insulating material comprises an opening (10), wherein the first, second and third pinholes (14) in the conducting layers (4) and the openings (10) in the first, second and third layers (6a 6b, 6c) of rigid insulating material are in communication with each other and form a common recess (15) in which the first, second and third conducting pins (16a, 16b and 16c) are located, said common recess (15) being filled with a resin forming a material bridge (12) which mechanically clamps said conducting layers (4) and said layers (6a to 6c) of rigid insulating material.

4. Multi-phase busbar according to claim 3,
**characterized in that** a fourth layer (6d) of rigid insulating material having an opening (10) which matches the first second and third pinholes (14a, 14b, 14c) in said second and third and fourth conducting layers (4b to 4d) is arranged on said fourth insulating layer (6d), said opening (10) communicating with said openings (10) in said first, second and third layer (6a to 6c) of insulating material and said pinholes (14a to 14d) in said conducting layers (4a to 4c), thereby forming a common recess (15) which is filled with a resin which forms a material bridge (12) that mechanically clamps the stack of conducting layers (4a to 4d) and layers (6a to 6d) of rigid insulating together.

5. Multi-phase busbar according to any of the preceding claims, **characterized in that** one or more of the conducting layers (4) are copper or aluminium layers, which are coated with an electrically insulating material, in particular which are coated with a coating including an epoxy resin.

6. Multi-phase busbar according to any of the preceding claims, **characterized in that** the layers (6) of rigid insulating material consist of GPO-3.

7. Multi-phase busbar according to any of the preceding claims 1 to 4, **characterized in that** one or more of the conducting layers (4) are copper or aluminium layers, which are uncoated and comprise an electrically conducting surface.

8. Multi-phase busbar according to any of the preceding claims, **characterized in that** the resin (17) is a thermosetting resin or that the resin includes a photoinitiator.

9. Multi-phase busbar according to any of claims 2 to 8,
**characterized in that** at least the first pinholes (14a) in the second, third and fourth conducting layers (14b to 14d) and the openings (10) in the first, second and third layer (6a to 6c) of insulating material are aligned with each other.

10. Multi-phase busbar according to any of the claims 2 to 9,
**characterized in that** the at least one opening (10) formed in the second layer (6b) of rigid insulating material comprises a continues edge (10a) which surrounds at least the first and the second conducting pins (16a, 16b).

11. Multi-phase busbar according to any of the claims 2 to 10, **characterized in that** the opening (10) in the first layer (6a) of rigid insulating material comprises an area which is at least four times as large as the area of the cross section of the first pinhole (14a).

12. Multi-phase busbar according to any of claims 2 to 10,
**characterized in that** the first and second and/or the third layers (6a to 6c) of rigid insulating material are substantially identical.

13. Multi-phase busbar according to any of the previous claims, **characterized in that** the end portions of conducting layers (4) comprise conducting edge portions in which no insulating coating (5) is applied to the sheet metal.

14. Method of manufacturing a multi-phase busbar according to any of the preceding claims **characterized by** the following method steps:
- forming a stack including
**a)** a first conducting layer
**b)** first layer of a rigid insulating material loosely arranged on said first conducting layer,
**c)** a second conducting layer loosely arranged on said first layer of rigid insulating material and
**d)** a second insulating layer loosely arranged on said second conducting layer,
- wherein said second conducting layer comprises a first pin hole and said first conducting layer comprises a first conducting pin projecting through said first pinhole and a second conducting pin arranged at a distance to said first conducting pin and extending in a direction parallel to said first conducting pin, and
wherein said first layer of a rigid insulating material comprises an opening having a larger size than said first pinhole and extending between said first and second conducting layers so as to communicate with said first pinhole and form a common recess,
- pressing said first and second conducting layers against each other so as to mechanically clamp the first layer of rigid insulating material between said conducting layers,
- filling up said common recess with a curable resin and
- curing said resin while pressing said first and second conducting layers against each other.

## Patentansprüche

1. Mehrphasige Sammelschiene (1) zum Leiten von elektrischer Energie, umfassend eine erste leitende Schicht (4a), die aus einem Metallblech gefertigt ist, einen ersten leitenden Stift (16a), der an der ersten leitenden Schicht (4a) angebracht ist und der sich in einer Richtung senkrecht zu der ersten leitenden Schicht (4a) erstreckt, eine erste Isolierschicht (6a) aus einem starren Isoliermaterial, die auf der ersten leitenden Schicht (4a) angeordnet ist, wobei die erste Isolierschicht (6a) eine Öffnung aufweist (10), durch die der erste leitende Stift (16a) vorsteht, eine zweite leitende Schicht (4b), die aus einem Metallblech angefertigt ist, wobei die zweite leitende Schicht (4b) ein erstes Stiftloch (14a) umfasst, durch das der erste leitende Stift (16a) vorsteht, und einen zweiten leitenden Stift (16b), der sich in einer Richtung parallel zu dem ersten leitenden Stift (16a) erstreckt, wobei die Öffnung (10) in der ersten Isolierschicht (6a) und das erste Stiftloch (14a) in der zweiten leitenden Schicht (4b) eine gemeinsame Vertiefung (15) definieren, durch die der erste leitende Stift (16a) vorsteht,
**dadurch gekennzeichnet, dass** die Öffnung (10) in der ersten Schicht (6a) aus starrem Isoliermaterial eine Fläche umfasst, die größer ist als die Fläche des Querschnitts des ersten Stiftlochs (14a), und dadurch, dass die gemeinsame Vertiefung (15) mit einem gehärteten Harz (17) gefüllt ist, das eine Materialbrücke (12) zwischen der ersten leitenden Schicht (4a) und der zweiten leitenden Schicht (4b) ausbildet, welche die erste leitende Schicht (4a), die erste starre Isolierschicht (6a) und die zweite leitende Schicht (4b) mechanisch zusammenklammert.

2. Mehrphasige Sammelschiene nach Anspruch 1,
**dadurch gekennzeichnet, dass** eine zweite Isolierschicht (6b) aus einem starren Isoliermaterial auf der zweiten leitenden Schicht (4b) angeordnet ist, wobei die zweite Schicht (6b) aus gefurchtem Isoliermaterial eine Öffnung aufweist (10), die mit dem ersten Stiftloch (14a) übereinstimmt, wobei das erste Stiftloch (14a) in der zweiten leitenden Schicht (4b) und die Öffnungen (10) in der ersten und der zweiten Schicht (6a, 6b) aus Isoliermaterial eine gemeinsame Vertiefung (15) definieren, in welcher der erste und der zweite leitende Stift (16a, 16b) angeordnet sind und die mit Harz (17) gefüllt ist, das eine Materialbrücke (12) ausbildet, welche die erste und die zweite leitende Schicht (4a, 4b) und die erste und die zweite starre Isolierschicht (6a, 6b) mechanisch zusammenklammert.

3. Mehrphasige Sammelschiene nach Anspruch 1 oder 2,
**dadurch gekennzeichnet, dass** eine dritte und eine vierte Schicht (4c, 4d) aus einem leitenden Material und eine dritte Schicht (6c) aus einem starren Isoliermaterial übereinander auf der zweiten Schicht (6b) aus starrem Isoliermaterial angeordnet sind, wobei die dritte leitende Schicht (4c) ein erstes und ein zweites Stiftloch (14a, 14b) umfasst, die vierte leitende Schicht ein erstes, ein zweites und ein drittes Stiftloch (14a, 14b, 14c) umfasst und die dritte Schicht (6c) aus starrem Isoliermaterial eine Öffnung (10) umfasst, wobei das erste, das zweite und das dritte Stiftloch (14) in den leitenden Schichten (4) und die Öffnungen (10) in der ersten, der zweiten und der dritten Schicht (6a 6b, 6c) aus starrem Isoliermaterial miteinander in Verbindung stehen und eine gemeinsame Vertiefung (15) ausbilden, in welcher der erste, der zweite und der dritte leitende Stift (16a, 16b und 16c) angeordnet sind, wobei die gemeinsame Vertiefung (15) mit einem Harz gefüllt ist, das eine Materialbrücke (12) ausbildet, welche die leitenden Schichten (4) und die Schichten (6a bis 6c) aus starrem Isoliermaterial mechanisch klammert.

4. Mehrphasige Sammelschiene nach Anspruch 3,
**dadurch gekennzeichnet, dass** eine vierte Schicht (6d) aus starrem Isoliermaterial, die eine Öffnung aufweist (10), die mit dem ersten, dem zweiten und dem dritten Stiftloch (14a, 14b, 14c) in der zweiten und der dritten und der vierten leitenden Schicht (4b bis 4d) übereinstimmt, auf der vierten Isolierschicht (6d) angeordnet ist, wobei die Öffnung (10) mit den Öffnungen (10) in der ersten, der zweiten und der dritten Schicht (6a bis 6c) aus Isoliermaterial und den Stiftlöchern (14a bis 14d) in den leitenden Schichten (4a bis 4c) in Verbindung stehen, wodurch eine gemeinsame Vertiefung (15) ausgebildet wird, die mit einem Harz gefüllt ist, das eine Materialbrücke (12) ausbildet, die den Stapel aus leitenden Schichten (4a bis 4d) und aus Schichten (6a bis 6d) aus starrer Isolation mechanisch zusammenklammert.

5. Mehrphasige Sammelschiene nach einem der vorhergehenden Ansprüche,
**dadurch gekennzeichnet, dass** eine oder mehrere der leitenden Schichten (4) Kupfer- oder Aluminium-Schichten sind, die mit einem elektrisch isolierenden Material beschichtet sind, die insbesondere mit einer Beschichtung beschichtet sind, die ein Epoxid-Harz umfasst.

6. Mehrphasige Sammelschiene nach einem der vorhergehenden Ansprüche,
**dadurch gekennzeichnet, dass** die Schichten (6) aus starrem Isoliermaterial aus GPO-3 bestehen.

7. Mehrphasige Sammelschiene nach einem der vorhergehenden Ansprüche 1 bis 4,
**dadurch gekennzeichnet, dass** eine oder mehrere der leitenden Schichten (4) Kupfer- oder Aluminium-Schichten sind, die unbeschichtet sind und eine elektrisch leitende Oberfläche umfassen.

8. Mehrphasige Sammelschiene nach einem der vorhergehenden Ansprüche,
**dadurch gekennzeichnet, dass** das Harz (17) ein wärmeaushärtendes Harz ist, oder dass das Harz einen Fotoinitiator umfasst.

9. Mehrphasige Sammelschiene nach einem der Ansprüche 2 bis 8,
**dadurch gekennzeichnet, dass** mindestens die ersten Stiftlöcher (14a) in der zweiten, der dritten und der vierten leitenden Schicht (14b bis 14d) und die Öffnungen (10) in der ersten, der zweiten und der dritten Schicht (6a bis 6c) aus Isoliermaterial zueinander ausgerichtet sind.

10. Mehrphasige Sammelschiene nach einem der vorhergehenden Ansprüche 2 bis 9,
**dadurch gekennzeichnet, dass** die mindestens eine Öffnung (10), die in der zweiten Schicht (6b) aus starrem Isoliermaterial ausgebildet ist, einen durchgehenden Rand (10a) umfasst, der mindestens den ersten und den zweiten leitenden Stift (16a, 16b) umgibt.

11. Mehrphasige Sammelschiene nach einem der vorhergehenden Ansprüche 2 bis 10,
**dadurch gekennzeichnet, dass** die Öffnung (10) in der ersten Schicht (6a) aus starrem Isoliermaterial eine Fläche umfasst, die mindestens vier Mal so groß ist wie die Fläche des Querschnitts des ersten Stiftlochs (14a),

12. Mehrphasige Sammelschiene nach einem der Ansprüche 2 bis 10,
**dadurch gekennzeichnet, dass** die erste und die zweite und/oder die dritte Schicht (6a bis 6c) aus starrem Isoliermaterial im Wesentlichen identisch sind.

13. Mehrphasige Sammelschiene nach einem der vorhergehenden Ansprüche,
**dadurch gekennzeichnet, dass** die Endabschnitte von leitenden Schichten (4) leitende Randabschnitte umfassen, auf denen keine Isolierbeschichtung (5) auf dem Metallblech aufgebracht ist.

14. Verfahren zum Herstellen einer mehrphasigen Sammelschiene nach einem der vorhergehenden Ansprüche, **gekennzeichnet durch** die folgenden Verfahrensschritte:
- Ausbilden eines Stapels, Folgendes umfassend
**a)** eine erste leitende Schicht
**b)** eine erste Schicht aus einem starren Isoliermaterial, die lose auf der ersten leitenden Schicht angeordnet ist,
**c)** eine zweite leitende Schicht, die lose auf der ersten Schicht aus starrem Isoliermaterial angeordnet ist, und
**d)** eine zweite Isolierschicht, die lose auf der zweiten leitenden Schicht angeordnet ist,
- wobei die zweite leitende Schicht ein erstes Stiftloch umfasst und die erste leitende Schicht einen ersten leitenden Stift, der durch das erste Stiftloch vorsteht, und einen zweiten leitenden Stift umfasst, der in einem Abstand zu dem ersten leitenden Stift angeordnet ist und sich in einer Richtung parallel zu dem ersten leitenden Stift erstreckt, und
wobei die erste Schicht aus einem starren Isoliermaterial eine Öffnung mit einer größeren Abmessung als der des ersten Stiftlochs umfasst und sich zwischen der ersten und der zweiten leitenden Schicht erstreckt, um so mit dem ersten Stiftloch in Verbindung zu stehen und eine gemeinsame Vertiefung auszubilden,
- Drücken der ersten und der zweiten leitenden Schicht gegeneinander, um so die erste Schicht aus starrem Isoliermaterial zwischen den leitenden Schichten mechanisch zu klemmen,
- Auffüllen der gemeinsamen Vertiefung mit einem härtbaren Harz und
- Härten des Harzes beim Drücken der ersten und der zweiten leitenden Schicht gegeneinander.

## Revendications

1. Barre de distribution polyphasée (1) destinée à conduire l'énergie électrique, comprenant une première couche conductrice (4a) constituée d'une tôle métallique, une première broche conductrice (16a) montée sur ladite première couche conductrice (4a) qui s'étend dans une direction perpendiculaire à la première couche conductrice (4a), une première couche isolante (6a) d'un matériau isolant strié disposée sur ladite première couche conductrice (4a), ladite première couche isolante (6a) ayant une ouverture (10) à travers laquelle se projette la première broche conductrice (16a), une deuxième couche conductrice (4b) constituée d'une tôle métallique, ladite deuxième couche conductrice (4b) comprenant un premier trou d'épingle (14a) à travers lequel se projette ladite première broche conductrice (16a), et une deuxième broche conductrice (16b) qui s'étend dans une direction parallèle à ladite première broche conductrice (16a), ladite ouverture (10) dans ladite première couche isolante (6a) et ledit premier trou d'épingle (14a) dans ladite deuxième couche conductrice (4b) définissant une encoche commune (15) à travers laquelle se projette ladite première broche conductrice (16a),
**caractérisée en ce que** ladite ouverture (10) dans la première couche (6a) de matériau isolant rigide présente une superficie qui est plus grande que la superficie de la section transversale du premier trou d'épingle (14a), et **en ce que** ladite encoche commune (15) est remplie avec une résine durcie (17) qui forme un pont de matière (12) entre la première couche conductrice (4a) et la deuxième couche conductrice (4b), qui serre ensemble mécaniquement ladite première couche conductrice (4a), ladite première couche isolante rigide (6a) et ladite deuxième couche conductrice (4b).

2. Barre de distribution polyphasée selon la revendication 1, **caractérisée en ce qu'**une deuxième couche isolante (6b) d'un matériau isolant strié est disposée sur ladite deuxième couche conductrice (4b), ladite deuxième couche (6b) de matériau isolant strié ayant une ouverture (10) qui correspond audit premier trou d'épingle (14a), ledit premier trou d'épingle (14a) dans ladite deuxième couche conductrice (4b) et lesdites ouvertures (10) dans lesdites première et deuxième couches (6a, 6b) de matériau isolant définissant une encoche commune (15) dans laquelle sont situées la première et la deuxième broche conductrice (16a, 16b) et qui est remplie avec de la résine (17) formant un pont de matière (12) qui serre ensemble mécaniquement lesdites première et deuxième couches conductrices (4a, 4b) et lesdites première et deuxième couches isolantes rigides (6a, 6b).

3. Barre de distribution polyphasée selon la revendication 1 ou 2, **caractérisée en ce qu'**une troisième et une quatrième couche (4c, 4d) d'un matériau conducteur et une troisième couche (6c) d'un matériau isolant rigide sont disposées les unes au-dessus des autres sur ladite deuxième couche (6b) de matériau isolant rigide, ladite troisième couche conductrice (4c) comprenant un premier et un deuxième trou d'épingle (14a, 14b), ladite quatrième couche conductrice comprenant un premier, un deuxième et un troisième trou d'épingle (14a, 14b, 14c), et ladite troisième couche (6c) de matériau isolant rigide comprenant une ouverture (10), les premier, deuxième et troisième trous d'épingle (14) dans les couches conductrices (4) et les ouvertures (10) dans les première, deuxième et troisième couches (6a, 6b, 6c) de matériau isolant rigide étant en communication les uns avec les autres et formant une encoche commune (15) dans laquelle sont situées les première, deuxième et troisième broches conductrices (16a, 16b, 16c), ladite encoche commune (15) étant remplie avec une résine formant un pont de matière (12) qui serre mécaniquement lesdites couches conductrices (4) et lesdites couches (6a à 6c) de matériau isolant rigide.

4. Barre de distribution polyphasée selon la revendication 3,
**caractérisée en ce qu'**une quatrième couche (6d) de matériau isolant rigide ayant une ouverture (10) qui correspond aux premier, deuxième et troisième trous d'épingle (14a, 14b, 14c) dans lesdites deuxième et troisième et quatrième couches conductrices (4b à 4d) est disposée sur ladite quatrième couche isolante (6d), ladite ouverture (10) communiquant avec lesdites ouvertures (10) dans lesdites première, deuxième et troisième couches (6a à 6c) de matériau isolant et lesdits trous d'épingle (14a à 14d) dans lesdites couches conductrices (4a à 4c), formant ainsi une encoche commune (15) qui est remplie avec une résine qui forme un pont de matière (12) qui serre ensemble mécaniquement l'empilement de couches conductrices (4a à 4d) et de couches isolantes rigides (6a à 6d).

5. Barre de distribution polyphasée selon l'une quelconque des revendications précédentes,
**caractérisée en ce qu'**une ou plusieurs des couches conductrices (4) sont des couches de cuivre ou d'aluminium, qui sont recouvertes d'un matériau électriquement isolant, en particulier qui sont recouvertes d'un revêtement comportant une résine époxy.

6. Barre de distribution polyphasée selon l'une quelconque des revendications précédentes,
**caractérisée en ce que** les couches (6) de matériau isolant rigide consistent en du GPO-3.

7. Barre de distribution polyphasée selon l'une quelconque des revendications 1 à 4,
**caractérisée en ce qu'**une ou plusieurs des couches conductrices (4) sont des couches de cuivre ou d'aluminium, qui ne sont pas recouvertes et comprennent une surface électriquement conductrice.

8. Barre de distribution polyphasée selon l'une quelconque des revendications précédentes,
**caractérisée en ce que** la résine (17) est une résine thermodurcissable ou **en ce que** la résine comporte un photoinitiateur.

9. Barre de distribution polyphasée selon l'une quelconque des revendications 2 à 8,
**caractérisée en ce qu'**au moins les premiers trous d'épingle (14a) dans les deuxième, troisième et quatrième couches conductrices (14b à 14d) et les ouvertures (10) dans les première, deuxième et troisième couches (6a à 6c) de matériau isolant sont alignés les uns avec les autres.

10. Barre de distribution polyphasée selon l'une quelconque des revendications 2 à 9,
**caractérisée en ce que** l'au moins une ouverture (10) formée dans la deuxième couche (6b) de matériau isolant rigide comprend un bord continu (10a) qui entoure au moins la première et la deuxième broche conductrice (16a, 16b).

11. Barre de distribution polyphasée selon l'une quelconque des revendications 2 à 10,
**caractérisée en ce que** l'ouverture (10) dans la première couche (6a) de matériau isolant rigide présente une superficie qui est au moins quatre fois plus grande que la superficie de la section transversale du premier trou d'épingle (14a).

12. Barre de distribution polyphasée selon l'une quelconque des revendications 2 à 10,
**caractérisée en ce que** la première et la deuxième et/ou la troisième couche (6a à 6c) de matériau isolant rigide sont sensiblement identiques.

13. Barre de distribution polyphasée selon l'une quelconque des revendications précédentes,
**caractérisée en ce que** les parties d'extrémité de couches conductrices (4) comprennent des parties de bord conductrices dans lesquelles aucun revêtement isolant (5) n'est appliqué à la tôle métallique.

14. Procédé de fabrication d'une barre de distribution polyphasée selon l'une quelconque des revendications précédentes, **caractérisé par** les étapes de procédé suivantes :
- formation d'un empilement comportant
a) une première couche conductrice,
b) une première couche d'un matériau isolant rigide disposée de façon lâche sur ladite première couche conductrice,
c) une deuxième couche conductrice disposée de façon lâche sur ladite première couche de matériau isolant rigide, et
d) une deuxième couche isolante disposée de façon lâche sur ladite deuxième couche conductrice,
- ladite deuxième couche conductrice comprenant un premier trou d'épingle et ladite première couche conductrice comprenant une première broche conductrice se projetant à travers ledit premier trou d'épingle et une deuxième broche conductrice disposée à une distance de ladite première broche conductrice et s'étendant dans une direction parallèle à ladite première broche conductrice, et
ladite première couche d'un matériau isolant rigide comprenant une ouverture ayant une plus grande taille que ledit premier trou d'épingle et s'étendant entre lesdites première et deuxième couches conductrices de manière à communiquer avec ledit premier trou d'épingle et former une encoche commune,
- pressage desdites première et deuxième couches conductrices l'une contre l'autre de manière à serrer mécaniquement la première couche de matériau isolant rigide entre lesdites couches conductrices,
- remplissage de ladite encoche commune avec une résine durcissable, et
- durcissement de ladite résine tout en pressant lesdites première et deuxième couches conductrices l'une contre l'autre.
